# EUROPÄISCHE PATENTSCHRIFT

(11) **EP 3 737 583 B1**
(45) Veröffentlichungstag und Bekanntmachung des Hinweises auf die Patenterteilung: **13.03.2024**
(21) Anmeldenummer: 19700770.1
(22) Anmeldetag: 08.01.2019
(51) Int. Cl.: B60N 2/56, B60N 2/58, B60N 2/70, H05B 3/34

(54) **FAHRZEUGSITZ MIT EINER ELEKTRISCHEN HEIZEINRICHTUNG**
VEHICLE SEAT HAVING AN ELECTRIC HEATING DEVICE
SIÈGE DE VÉHICULE COMPRENANT UN ÉQUIPEMENT DE CHAUFFAGE ÉLECTRIQUE

(30) Priorität: 10.01.2018 DE 102018200293
(43) Veröffentlichungstag der Anmeldung: 18.11.2020
(73) Patentinhaber: VOLKSWAGEN AKTIENGESELLSCHAFT, 38440 Wolfsburg (DE)
(72) Erfinder: MARKTSCHEFFEL, Jörg, 38162 Cremlingen (DE)
(74) Vertreter: Löbbecke, Carsten
(86) Internationale Anmeldenummer: PCT/EP2019/050269
(87) Internationale Veröffentlichungsnummer: WO 2019/137877

(56) Entgegenhaltungen:
- WO-A1-2009/049577
- US-A1- 2008 206 553

## Beschreibung

Die Erfindung betrifft einen mit einer elektrischen Heizeinrichtung ausgestatteten Fahrzeugsitz mit einer Polsterfläche.

Sitzheizungen dienen der direkten Erwärmung der Sitzfläche und Rückenlehne von Fahrzeugsitzen. Sie bestehen meist aus Heizmatten, die wahlweise in die Polster oder den Sitzbezug eingearbeitet oder dazwischen eingeklebt werden. In diese Matten sind Drähte eingearbeitet, die sich bei elektrischer Bestromung erhitzen. Die entstehende Wärme wird über den Fahrzeugsitz direkt an die darauf sitzende Person abgegeben.

Mittels Sensoren und einer Steuereinheit wird die Sitzheizung geregelt. So kann zum einen die Energieabgabe bedarfsgerecht eingestellt werden. Zum anderen wird über die Sensoren die Reaktion der Heizeinrichtung überprüft, sodass eine Gesundheitsgefährdung durch Verbrennung an zu heißen Sitzen oder elektrische Kurzschlüsse an gebrochenen Heizleitern ausgeschlossen werden kann.

Grundsätzlich verursacht jede elektrische Spannung elektrische Felder und jeder elektrische Strom verursacht magnetische Felder. Quellen solcher elektromagnetischer Felder, die körpernah genutzt werden, wie insbesondere auch Sitzheizung, gelten als risikoreich in Bezug auf gesundheitsschädliche Auswirkungen. Daher dienen entsprechende Richtlinien der Begrenzung der Exposition der Bevölkerung gegenüber elektromagnetischen Feldern im Bereich bis 300 GHz.

Es ist auch bereits bekannt, dass elektrisch leitfähige Materialien, zum Beispiel Metalle, hochfrequente elektromagnetische Felder reflektieren. Metallfolien oder Metallgitternetze, aber auch metallisch bedampfte Substrate können hochfrequente elektromagnetische Felder daher vollständig oder teilweise abschirmen.

Die WO 2009 / 049 577 A1 beschreibt bereits einen mit einer elektrischen Heizeinrichtung ausgestatteten Fahrzeugsitz mit einer Polsterfläche und mit Leiteinrichtungen, Leitsträngen oder Heizeinrichtungen, die an ihrer Oberfläche einen Mantel aufweisen, der elektrisch leitfähig zur EMV-Schirmung ausgeführt ist. Hierzu werden beispielsweise Metalle, vorzugsweise Legierungen aus Nickel, Silber, Kupfer oder Gold, als Beschichtung aufgebracht. Außerdem können auf der Unterseite eines zu beheizenden Bezugs Teilbereiche mit elektrisch leitfähigen Partikeln aus einem Heizwiderstandsmaterial beflockt werden, wobei die entsprechenden leitfähigen Widerstandspartikel durch Sprühen oder Drucken aufgebracht werden können.

Die DE 10 2009 003 867 A1 bezieht sich auf ein elektrisch leitendes Polymerband oder Polymergewebe auf der Basis von elektrisch leitenden Polymerfasern für flächenhafte Heizelemente, beispielsweise für eine Sitzheizung für Kraftfahrzeugsitze. Ein elektrisch leitendes, mehrfaches Wirkband kann mit einer Isolationsschicht versehen sein, in der eine Abschirmung aus einem Metallgeflecht oder einem elektrisch leitenden Polymergeflecht eingebettet ist, wodurch das Heizelement von elektromagnetischer Strahlung befreit wird.

Aus der DE 10 2013 100 792 A1 sind Polymerheizgewebe für flächenhafte Heizelemente, insbesondere für Sitzheizungen in Stadionsitzen oder Skiliften, bekannt. Auf eine Isolationsschicht mit Trägermaterialien aus Glasgewebe, Polymergewebe oder Vlies folgt eine Klebeschicht aus Composite-Harz mit einer elektromagnetischen Abschirmung.

Die DE 11 2015 001 591 T5 bezieht sich auf eine Sitzheizung mit einer Schichtungsstruktur, bei der die Heizschicht von jeweils einer Isolierschicht eingeschlossen ist.

Die EP 2 352 974 B1 offenbart eine Sitzheizung mit einer Störungsverminderungsstruktur aus leitfähigem Material zur Minimierung potentieller Störungen einer Antennenfunktion, die durch den Betrieb der Sitzheizung verursacht wird.

Vor diesem Hintergrund liegt der Erfindung die Aufgabe zugrunde, bei einer elektrischen Heizeinrichtung der eingangs genannten Art mit geringem Aufwand einen optimalen Schutz der den Sitz benutzenden Person vor elektromagnetischer Strahlung im Gebrauch der Heizeinrichtung zu erreichen.

Diese Aufgabe wird gelöst mit einem Fahrzeugsitz gemäß den Merkmalen des Patentanspruches 1. Die Unteransprüche betreffen besonders zweckmäßige Weiterbildungen der Erfindung.

Erfindungsgemäß ist also ein Fahrzeugsitz vorgesehen, bei dem zwischen der Polsterfläche und der Heizeinrichtung zumindest abschnittsweise ein zur Abschirmung gegenüber elektromagnetischer Strahlung geeignetes Material flächig angeordnet ist. Hierdurch wird in überraschend einfacher Weise eine für den optimalen Schutz des Fahrzeuginsassen erforderliche Abschirmung durch Anbringen, beispielsweise Auflegen einer oder mehrere Lagen eines insbesondere flächigen Materials mit entsprechender Abschirmungseignung gegenüber elektromagnetischer Strahlung erreicht. Indem das Material ein Substrat mit einer Vielzahl von Lamellen aufweist, in deren Zwischenräumen das Übergangsmetall eingebettet ist, sodass durch eine sinnvolle Orientierung der beispielsweise durch Einschnitte in dem Substrat realisierten Lamellen eine zusätzliche Fixierung der Metallpartikel oder des Metallpulvers entbehrlich ist, eignet sich diese Variante auch für an sich bereits bekannte Polsterelemente, die lediglich mit entsprechenden Schnitten versehen werden müssen. Selbstverständlich kann das Metall auch in Form von Fasern verwendet werden. Dabei weist das Material ein Substrat auf, dem ein Übergangsmetall in Form von Metallpartikeln als Schüttgut und/oder in Pulverform zugegeben ist, sodass in besonders einfacher Weise die gewünschte Abschirmung durch Metallpulver- oder Metallpartikelzugabe erreicht werden kann, die dem Substrat beigemischt oder auf dieses aufgetragen und gegebenenfalls durch ein zusätzliches Adhäsionsmittel fixiert werden. Selbstverständlich können als Substrat auch Elemente der Polsterung verwendet werden.

Dabei erweist es sich als besonders zweckmäßig, wenn das flächige Material als einen wesentlichen Materialanteil einen Schaum, insbesondere Schnittschaum, und/oder ein Vlies aufweist oder aus diesem aufgebaut ist. Der Schaum oder das Vlies können dabei als ein ebenes Flächenmaterial verarbeitet werden oder aber als konturierte Formkörper vorgefertigt und in die Sitzfläche und/oder Rücklehne eingearbeitet werden. Dadurch kann das Material neben der abschirmenden Wirkung zugleich auch Polsterfunktionen aufweisen und somit den Sitzkomfort verbessern.

Weiterhin hat es sich als besonders praxisgerecht erwiesen, wenn das flächige Material Zugaben zumindest eines Übergangsmetalls, insbesondere von Kupfer, Zink und/ oder Nickel, aufweist, durch die nach den derzeitigen Erkenntnissen eine hervorragende Abschirmwirkung erreicht werden kann. Beispielsweise kann das Material als ein Geflecht, Gewirke oder Gestricke eines drahtförmigen Materials realisiert werden, wobei zur Erzielung der gewünschten flexiblen Eigenschaften auch eine Kombination mit synthetischen Fasern nicht ausgeschlossen ist. Zudem kann die Menge des eingesetzten Metalls bezogen auf den Flächenbereich örtlich unterschiedlich bemessen sein, um so beispielsweise dem Verlauf der Heizeinrichtung entsprechend folgen und die Abschirmung so auf solche Bereiche konzentrieren zu können, die mit der Anordnung der Heizeinrichtung übereinstimmen.

Weiterhin ist es von Vorteil, wenn gemäß einer weiteren Variante der Erfindung das flächige Material in mehreren Lagen aufgebracht wird, um so die gewünschte Abschirmwirkung weiter zu verbessern. Hierdurch kann eine optimale Anpassung an die erforderliche Abschirmung durch eine entsprechende Anzahl von Lagen oder Schichten erreicht werden. Diese können beispielsweise relativ zueinander beweglich sein, um so die gewünschten flexiblen Eigenschaften innerhalb des Polsterelementes nicht zu beeinträchtigen.

Besonders bevorzugt beträgt die Materialstärke einer einzelnen Lage oder Schicht des flächigen Materials zwischen 0,05 mm und 0,5 mm, insbesondere zwischen 0,1 mm und 0,2 mm, sodass in der Praxis eine breite Anwendungsmöglichkeit bei nahezu beliebig konturierten Polsterflächen geschaffen wird.

Die Erfindung lässt zahlreiche Ausführungsformen zu. Zur weiteren Verdeutlichung ihres Grundprinzips ist eine davon in der Zeichnung dargestellt und wird nachfolgend beschrieben.

Diese zeigt in
- Fig. 1: einen mit einer elektrischen Heizeinrichtung ausgestatteten Fahrzeugsitz in einer perspektivischen Darstellung;
- Fig. 2: einen Schichtaufbau einer Polsterfläche des in Figur 1 gezeigten Fahrzeugsitzes in einem Querschnitt;
- Fig. 3: die in Figur 2 gezeigte Polsterfläche mit einem flächigen Material zur Abschirmung gegenüber elektromagnetischer Strahlung in einer Draufsicht.

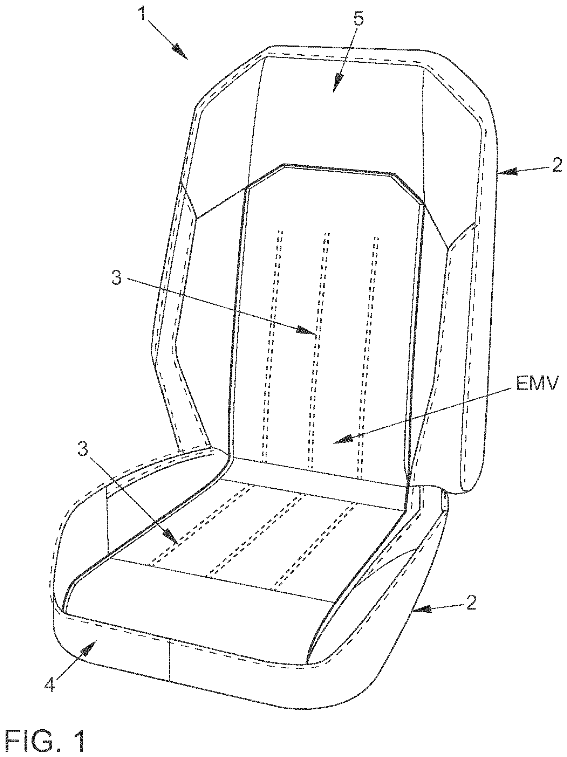

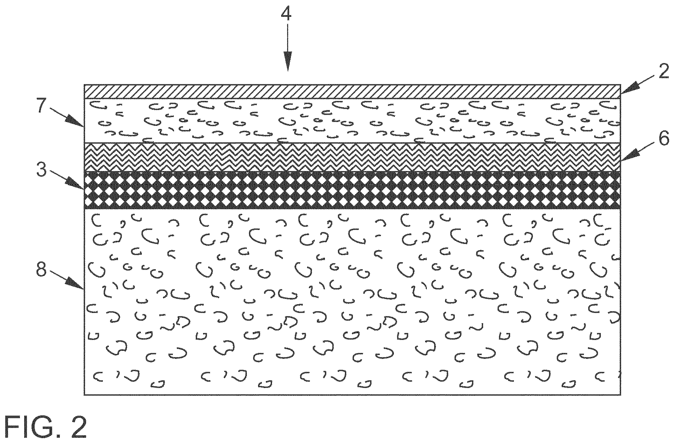

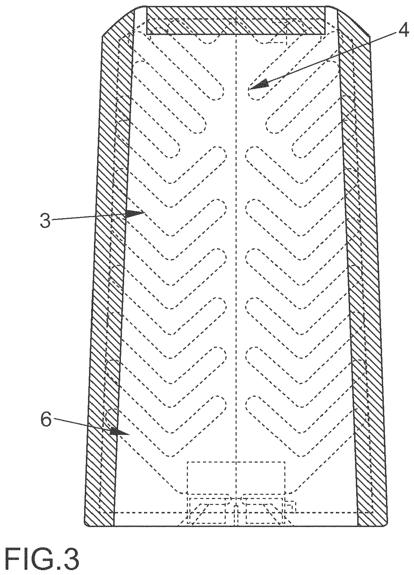

Ein erfindungsgemäßer Fahrzeugsitz 1 mit einer Polsterfläche 2 und mit einer integrierten elektrischen Heizeinrichtung 3 wird nachstehend anhand der Figuren 1 bis 3 näher erläutert. Derartige Heizeinrichtungen 3 zur Beheizung einer Sitzfläche 4 oder einer Rückenlehne 5 erzeugen im Betrieb ein elektromagnetisches Feld EMV, das ab einer bestimmten Feldstärke zu Beeinträchtigungen führen kann. Um solch unerwünschte Einflüsse zu vermeiden oder zumindest wesentlich zu reduzieren, ist zwischen der Polsterfläche 2 und der Heizeinrichtung 3 zumindest abschnittsweise ein zur Abschirmung gegenüber elektromagnetischer Strahlung geeignetes flächiges Material 6 angeordnet. Dieses beispielsweise als abschirmender Schnittschaum ausgeführte Material 6 oberhalb der Heizeinrichtung 3 sorgt dafür, dass die geltenden Grenzwerte im Betrieb der Sitzheizung nicht überschritten werden. Ein solcher Schnittschaum enthält zu diesem Zweck vollflächig oder partiell abschirmende Komponenten, wie beispielsweise Kupfer- oder Nickelpulver, als abschirmende Materialien. Um dabei den Sitzkomfort und die technischen Anforderungen an die Sitzheizung nicht einzuschränken, ist wie insbesondere aus Figur 2 erkennbar, oberhalb des als Abschirmung dienenden flächigen Materials 6 eine weitere Schaumkaschierung 7 an der Innenseite der Polsterfläche 2 vorgesehen, die gemeinsam mit dem unterhalb der Heizeinrichtung 3 angeordneten Formschaum 8 der Sitzfläche 4 oder der Rückenlehne 5 für den gewünschten Komfort sorgt.

### Bezugszeichenliste

- 1: Fahrzeugsitz
- 2: Polsterfläche
- 3: Heizeinrichtung
- 4: Sitzfläche
- 5: Rückenlehne

- 6: Material
- 7: Schaumkaschierung
- 8: Formschaum
- EMV: elektromagnetisches Feld

## Patentansprüche

1. Ein mit einer elektrischen Heizeinrichtung (3) ausgestatteter Fahrzeugsitz (1) mit einer Polsterfläche (2), wobei zwischen der Polsterfläche (2) und der Heizeinrichtung (3) zumindest abschnittsweise ein zur Abschirmung gegenüber elektromagnetischer Strahlung (EMV) geeignetes Material (6) flächig angeordnet ist, **dadurch gekennzeichnet, dass** das Material (6) ein Substrat mit einer Vielzahl von Lamellen aufweist, in deren Zwischenräumen ein Übergangsmetall in Form von Metallpartikeln als Schüttgut und/oder in Pulverform eingebettet ist.

2. Fahrzeugsitz (1) nach Anspruch 1, **dadurch gekennzeichnet, dass** das flächige Material (6) als einen wesentlichen Anteil einen Schaum, insbesondere Schnittschaum, und/oder ein Vlies aufweist.

3. Fahrzeugsitz (1) nach den Ansprüchen 1 oder 2, **dadurch gekennzeichnet, dass** das flächige Material (6) Zugaben zumindest eines Übergangsmetalles, insbesondere von Kupfer, Zink und/oder Nickel aufweist.

4. Fahrzeugsitz (1) nach zumindest einem der vorangehenden Ansprüche, **dadurch gekennzeichnet, dass** das flächige Material (6) in mehreren Lagen angeordnet ist.

5. Fahrzeugsitz (1) nach Anspruch 4, **dadurch gekennzeichnet, dass** die Stärke einer einzelnen Lage oder Schicht des flächigen Materials (6) zwischen 0,05 mm und 0,5 mm, insbesondere zwischen 0,1 mm und 0,2 mm, beträgt.

## Claims

1. Vehicle seat (1) having an upholstered surface (2) equipped with an electric heating device (3), wherein a material (6) suitable for shielding against electromagnetic radiation (EMR) is arranged in the form of a sheet between the upholstered surface (2) and the heating device (3), at least in sections, **characterized in that** the material (6) comprises a substrate having a large number of lamellae in the spaces between which a transition metal is embedded in the form of metal particles in bulk and/or in powder form.

2. Vehicle seat (1) according to Claim 1, **characterized in that** the sheet material (6) comprises a foam, in particular a cut foam and/or a nonwoven, as a substantial portion.

3. Vehicle seat (1) according to Claims 1 or 2, **characterized in that** the sheet material (6) has additives of at least one transition metal, in particular of copper, zinc and/or nickel.

4. Vehicle seat (1) according to at least one of the preceding claims, characterized that the sheet material (6) is arranged in two or more layers.

5. Vehicle seat (1) according to Claim 4, **characterized in that** the thickness of a single layer or layer of the sheet material (6) is between 0.05 mm and 0.5 mm, especially between 0.1 mm and 0.2 mm.

## Revendications

1. Siège (1) de véhicule équipé d'un dispositif de chauffage électrique (3), comportant une surface (2) de coussin, entre la surface (2) de coussin et le dispositif de chauffage (3) étant disposé à plat au moins par sections un matériau (6) approprié au blindage contre un rayonnement électromagnétique (EMV), **caractérisé en ce que** le matériau (6) comporte un substrat comportant une pluralité de lamelles, dans les intervalles desquelles est incorporé un métal de transition sous forme de particules métalliques en tant que matière en vrac et/ou sous forme de poudre.

2. Siège (1) de véhicule selon la revendication 1, **caractérisé en ce que** le matériau plat (6) comporte en tant qu'une proportion importante une mousse, en particulier une mousse découpée, et/ou un non-tissé.

3. Siège (1) de véhicule selon la revendication 1 ou 2, **caractérisé en ce que** le matériau plat (6) comporte des additions d'au moins un métal de transition, en particulier de cuivre, zinc et/ou nickel.

4. Siège (1) de véhicule selon au moins l'une des revendications précédentes, **caractérisé en ce que** le matériau plat (6) est disposé en plusieurs couches.

5. Siège (1) de véhicule selon la revendication 4, **caractérisé en ce que** l'épaisseur d'une couche ou strate individuelle du matériau plat (6) est comprise entre 0,05 mm et 0,5 mm, en particulier entre 0,1 mm et 0,2 mm.
